(19) Europäisches Patentamt

European Patent Office

Office européen des brevets

(11) **EP 1 490 888 B1**

(12) **FASCICULE DE BREVET EUROPEEN**

(45) Date de publication et mention
de la délivrance du brevet:
**08.11.2006 Bulletin 2006/45**

(51) Int Cl.:
*H01J 37/256* (2006.01) *G01N 23/225* (2006.01)

(21) Numéro de dépôt: 03735792.8

(22) Date de dépôt: **28.03.2003**

(86) Numéro de dépôt international:
**PCT/FR2003/000987**

(87) Numéro de publication internationale:
**WO 2003/083892 (09.10.2003 Gazette 2003/41)**

(54) **DISPOSITIF DE MESURE DE L EMISSION DE RAYONS X PRODUITE PAR UN OBJET SOUMIS A UN FAISCEAU D ELECTRONS**

EINRICHTUNG ZUR MESSUNG DER EMISSION VON RÖNTGENSTRAHLEN, DIE DURCH EIN OBJEKT ERZEUGT WERDEN, DAS EINEM ELEKTRONENSTRAHL AUSGESETZT IST

DEVICE FOR MEASURING THE EMISSION OF X RAYS PRODUCED BY AN OBJECT EXPOSED TO AN ELECTRON BEAM

(84) Etats contractants désignés:
**AT BE BG CH CY CZ DE DK EE ES FI FR GB GR HU IE IT LI LU MC NL PT RO SE SI SK TR**

(30) Priorité: **29.03.2002 FR 0204074**

(43) Date de publication de la demande:
**29.12.2004 Bulletin 2004/53**

(73) Titulaire: **CAMECA**
**F-92400 Courbevoie (FR)**

(72) Inventeurs:
• **De Chambost, Emmanuel**
**Thales Intellectual Property**
**F-94117 Arcueil Cedex (FR)**
• **Hombourger, Chrystel**
**Thales Intellectual Property**
**F-94117 Arcueil Cedex (FR)**
• **Montero, Juan**
**Thales Intellectual Property**
**F-94117 Arcueil Cedex (FR)**
• **Montsallut, Pierre**
**Thales Intellectual Property**
**F-94117 Arcueil Cedex (FR)**
• **Staub,Pierre-François**
**Thales Intellectual Property**
**F-94117 Arcueil Cedex (FR)**

(74) Mandataire: **Lucas, Laurent Jacques**
**Marks & Clerk France**
**31-33 Avenue Aristide Briand**
**94117 Arcueil Cedex (FR)**

(56) Documents cités:
**WO-A-01/95365** **US-A- 3 760 180**
**US-A- 5 714 757**

**Description**

La présente invention porte sur un dispositif de mesure de l'émission de rayons X produite par un objet soumis à un faisceau d'électrons. Elle concerne notamment la réalisation d'un dispositif permettant de contrôler la qualité dé fabrication de circuits intégrés réalisés sur des tranches de silicium encore appelées "Wafers" dans la littérature anglo-saxonne. Le dispositif est destiné à effectuer des mesures de composition et d'épaisseur sur les structures conductrices et diélectriques constituant ces circuits intégrés. Le dispositif est également destiné à optimiser le temps d'analyse d'un wafer en sortie de fabrication.

Ce dispositif est notamment destiné à équiper des chaînes de fabrication de circuits intégrés.

Le besoin de pouvoir caractériser de manière quantitative des structures très fines, enfouies dans les premiers nanomètres des matériaux solides de type semi-conducteurs par exemple, ne cesse de croître au fil des années. C'est notamment le cas dans le domaine de la microélectronique. L'augmentation de la célérité des circuits électroniques est liée aux besoins du marché. Cet accroissement de la célérité passe par la réduction de la taille de ces circuits et donc des éléments de structure qui constituent les transistors

Ainsi, la taille minimum de ces transistors est passée de $2\mu m$ en 1980 à 180nm aujourd'hui. L'objectif visé est la mise en service de transistors ayant des tailles de 130nm et 100nm dans les années à venir et de 50nm par la suite.

La réalisation de tels transistors sub-microniques, implique de maîtriser les étapes de formation de structures très fines, dont l'épaisseur n'excède par exemple pas 50nm. Deux étapes de fabrication sont notamment très importantes :

- l'implantation ionique des porteurs de charges qui peut être réalisée sur une épaisseur n'excédant pas d'ores et déjà quelques nanomètres avant activation.
- le recouvrement du transistor par un matériau diélectrique de grille, sous forme d'une couche de matériau dont l'épaisseur est désormais parfois inférieure au nanomètre.

Des épaisseurs de cet ordre représentent des quantités d'atomes typiquement comprises entre $10^{13}$ et $10^{16}$ atomes par $cm^2$.

Face aux difficultés de réalisation, les fabricants de semi-conducteurs sont à la recherche de dispositifs industriels d'analyse, capables de caractériser de manière fiable les structures sub-microniques réalisées. Ces dispositifs doivent être suffisamment sensibles et précis pour pouvoir quantifier et contrôler avec exactitude, typiquement à 1% près, les caractéristiques de composition et d'épaisseur des structures fabriquées. Ces dispositifs doivent également avoir une résolution suffisante pour permettre un contrôle analytique sur des zones très petites, dédiées à ces tests et situées en bordure des puces électroniques. La taille des zones de test est typiquement de l'ordre $100\mu m$ x $100\mu m$.

Ces dispositifs doivent en outre établir des diagnostics, dans des temps compatibles des contraintes liées à l'environnement de production. Ces temps sont par exemple de l'ordre de quelques minutes pour l'inspection d'un wafer.

Les structures élaborées devenant de plus en plus fines, leur contrôle nécessite de pouvoir réaliser des mesures de plus en plus précises. En regard des ordres de grandeur des mesures à effectuer, les dispositifs actuellement disponibles sur le marché sont inappropriés et affichent des performances insuffisantes. Ce manque de performance touche plusieurs aspects, depuis le manque de précision dans les résultats quantitatifs jusqu'au manque pur et simple de sensibilité.

Un but de l'invention est notamment de répondre aux exigences citées dans ce qui précède. A cet effet l'invention a pour objet un dispositif de mesure de l'émission de rayons X, produite par un objet soumis à un faisceau d'électrons. L'invention se situe dans le champ de la technique connue internationalement sous l'acronyme d'EPMA (Electron Probe Micro Analysis) qui combine le bombardement d'objets par faisceau électronique avec la détection de la longueur d'ondes des rayons X produits par l'interaction electrons-échantillon. Un exemple de dispositif instrumental mettant en oeuvre la technique EPMA est le SX100 développé par la déposante et décrit notamment dans les chapitres 1 et 5 de l'ouvrage intitulé "Microanalyse et Microscopie électronique à Balayage", publié par Les Editions de Physique en 1979.

Dans le contexte des techniques connues mettant en oeuvre un bombardement d'objets par faisceau électronique on peut également citer la technique AUGER qui met en oeuvre un procédé basé sur l'analyse de l'énergie des électrons émis par l'échantillon analysé. On peut notamment citer à ce titre te brevet US 3,760,180 A, déposé par la société SIEMENS et délivré le 18 septembre 1973. Ce brevet décrit une instrumentation combinant des moyens d'optique électronique pour bombarder l'échantillon et un analyseur d'énergie des électrons de type AUGER.

Le dispositif selon l'invention comporte principalement:

- Un sous-ensemble comportant des moyens d'émission d'électrons et Un étage d'accélération dans lequel les électrons sont soumis à une différence de potentiel $\Delta V1$;
- Un espace sans champ électrique dans lequel le faisceau d'électrons est mis en forme et contrôlé par des moyens appropriés;

Un étage de freinage dans lequel les électrons sont soumis à une différence de potentiel ΔV2 de même signe que ΔV1;
Un support permettant de positionner l'objet sous le faisceau d'électrons:
Des moyens d'analyse spectrale des rayonnements X émis par l'objet analysé;

Ce dispositif présente l'avantage d'émettre un faisceau d'électrons de faible dimension, compatible avec les contraintes de résolution citées précédemment.

Le faisceau d'électron présente peu de dispersion ce qui assure une bonne précision d'éclairement.

La profondeur de pénétration du faisceau d'électrons à l'intérieur du matériau à analyser est réglable et permet avantageusement d'obtenir une sensibilité compatible avec les contraintes liées à la finesse des couches analysées.

L'intensité du courant d'électrons produit permet également d'accroître la sensibilité du dispositif.

D'autres caractéristiques et avantages de l'invention apparaîtront à l'aide de la description qui suit, faite en regard des figures annexées qui représentent :

La figure 1, une représentation schématique du dispositif.
La figure 2, une représentation schématique du trajet du faisceau d'électrons.
La figure 3, une illustration de l'action du champ retardateur sur un faisceau d'électrons.
La figure 4, une architecture possible d'un système d'automatisation du dispositif.

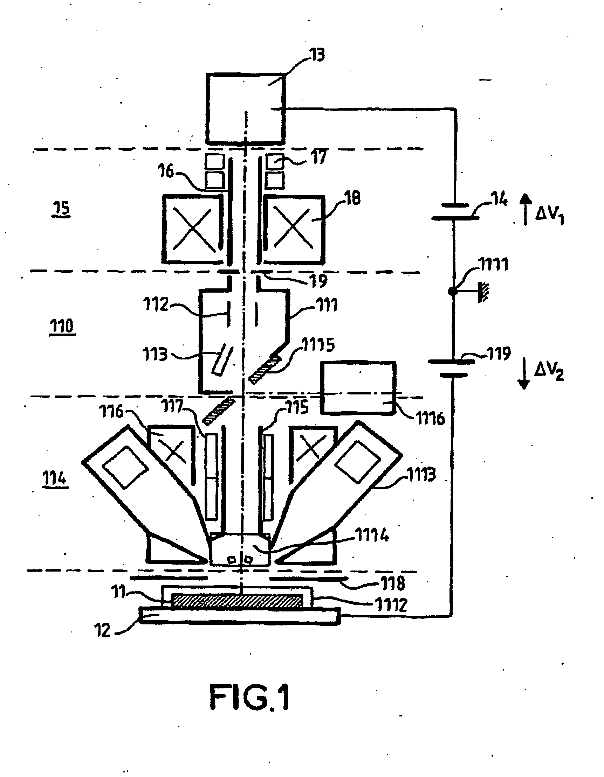

Le dispositif selon l'invention est représenté sur la figure 1. Il comporte principalement un sous-ensemble appelé colonne électronique, destiné à l'émission, à la formation et au pilotage du faisceau d'électrons, un sous-ensemble réalisant l'analyse spectrale des émissions de rayons × caractéristiques de l'objet analysé et un support d'échantillon 12 sur lequel est placé l'échantillon 11 à analyser. Il comporte également un sous-ensemble optique permettant la visualisation de l'échantillon 11. D'autres sous-ensembles peuvent être intégrés au dispositif, pour réaliser des fonctions annexes ou complémentaires comme notamment des moyens de commande automatique ou encore des moyens permettant de modifier la position de l'échantillon par rapport au faisceau. L'ensemble du dispositif est placé dans une enceinte, non représentée sur la figure, dans lequel règne un vide plus ou moins poussé selon les besoins.

La colonne électronique comporte plusieurs parties, chaque partie comportant elle-même plusieurs éléments. Le sous-ensemble 13 destiné à l'émission et à l'accélération du faisceau d'électrons est l'élément de la colonne situé le plus en amont. Il comporte notamment une source d'électrons portée à un potentiel HV1 et un étage d'accélération des électrons.
La source électronique peut être de nature diverse, notamment une Source froide à effet de champ, une source Schottky à cathode ponctuelle ou encore une source à cathode thermoémissive. Le potentiel HV1 est appliqué à la source au moyen d'un générateur 14.
Au niveau de l'étage d'accélération les électrons sont soumis à une différence de potentiel ΔV1 égale par exemple à la tension délivrée par le générateur 14. Cette différence de potentiel est telle qu'elle crée un champ électrique qui accélère les électrons émis par la source.

Les électrons ainsi accélérés quittent le sous-ensemble émission 13 et abordent un espace soumis à un champ électrique sensiblement nul, dans lequel ils conservent une énergie pratiquement constante. Dans cet espace sans champ se forme et se propage le faisceau d'électrons. Cet espace sans champ comporte lui-même plusieurs zones.

Une première zone 15 de formation du faisceau est située immédiatement en aval du dispositif d'émission. Cette zone est entourée d'une enceinte 16 métallisée intérieurement qui peut par exemple prendre la forme d'un tube. Cette enceinte est portée au potentiel de référence 1111 du générateur 14. Le potentiel de référence peut par exemple être la masse de l'ensemble du dispositif selon l'invention.

Autour de l'enceinte 16, juste en aval de la source, sont disposés des éléments déviateurs 17, par exemple magnétiques, dont le rôle est d'ajuster la position ou la direction du faisceau d'électrons.

Autour de l'enceinte 16 est également disposée une lentille magnétique 18 qui permet de donner au faisceau d'électrons une forme tubulaire, non focalisé, dans lequel les électrons suivent des trajectoires parallèles.

A la sortie de l'enceinte 16 est positionné un diaphragme 19 dont le rôle consiste à limiter le diamètre du faisceau d'électrons. Cette limitation du diamètre du faisceau a notamment pour rôle de faire en sorte que le diamètre du faisceau qui attaque le plan de l'échantillon ne dépasse pas la valeur maximum voulue. Ce diamètre maximum est par exemple celui requis par la résolution spectrale des spectromètres ou bien la résolution spatiale nécessaire pour la mesure.
Ce diaphragme peut être un élément unique avec une ouverture de diamètre fixe. Il peut également être constitué d'un ensemble de diaphragmes commutables ayant des diamètres d'ouverture différents.
La commutation de diaphragmes de diamètres différents est un moyen avantageux qui permet de faire varier l'intensité du faisceau sans modifier les caractéristiques de la source d'électrons.

L'espace sans champ électrique comporte une deuxième zone 110 de mesure du courant d'électrons. Cette zone est par exemple située en aval du diaphragme. Elle est entourée d'une enceinte conductrice 111 portée comme l'enceinte 16 au potentiel de référence du générateur 14.

A l'intérieur de l'enceinte 111, des moyens de déflexion 112 sont disposés autour du faisceau. Ces moyens de déflexion sont destinés à dévier le faisceau de son trajet normal vers l'échantillon à analyser. Le faisceau ainsi dévié est dirigé vers un dispositif 113 qui mesure la densité du flux d'électrons. Ce dispositif capteur d'électrons, de type puits de Faraday par exemple, est également positionné dans l'enceinte 111 et isolé électriquement.

Les moyens de déflexion 112, qui peuvent par exemple être des bobines magnétiques ou des plaques électrostatiques, sont mis en service périodiquement. Ceci permet avantageusement d'effectuer une mesure périodique du courant d'électrons. Le choix des moyens de déflexion utilisés est fonction de la rapidité et de la cadence de mesure souhaitées. Pour actionner ces moyens de déflexion, l'invention comporte également un dispositif de commande ayant des temps très courts de mise en et hors service. Ce dispositif, non représenté sur la figure, permet de défléchir périodiquement le faisceau pendant de courts instants et d'effectuer des mesures de courant en cours d'utilisation du faisceau. Ainsi avec des temps de commutation inférieurs, par exemple, à la microseconde on peut effectuer une mesure d'une milliseconde tous les dixièmes de seconde. On obtient alors une mesure par échantillonnage de l'intensité du faisceau. L'expérience montre que si l'on procède à une mesure de l'intensité pendant 1 % du temps, la mesure est réalisée avec une précision suffisante et laisse le faisceau disponible pour l'analyse pendant 99% du temps.

L'enceinte 111 renferme les moyens de mesure du courant d'électrons : Il y a donc avantage à la placer, en aval de tout élément destiné à limiter la taille du faisceau, comme par exemple un diaphragme. Ainsi, le courant de faisceau mesuré est le même que le courant de faisceau qui atteint l'échantillon.

L'espace sans champ électrique comporte une troisième zone 114 de focalisation du faisceau. Cette zone est par exemple située en aval de la zone 110 décrite précédemment. Cette zone est entourée d'une enceinte conductrice 115 qui entoure le faisceau et qui est portée comme les enceintes 16 et 111, au potentiel de référence du générateur 14.

Autour de l'enceinte 115 est disposée une lentille magnétique 116 dont le rôle est de focaliser le faisceau d'électrons sur un point de la surface de l'échantillon à analyser. Cette lentille peut être considérée, par analogie optique, comme l'objectif du système.

Entre la lentille 116 et l'enceinte 115 entourant le faisceau, il est possible de disposer des déflecteurs. Ces dispositifs déflecteurs 117 pourront servir à positionner ou à déplacer le faisceau sur l'échantillon pour effectuer un balayage.

Dès sa sortie de l'enceinte 115 le faisceau quitte l'espace sans champ électrique et aborde le voisinage de l'échantillon à analyser avec une énergie sensiblement identique à leur énergie initiale.

En aval de l'enceinte 115, le dispositif selon l'invention comporte une plaque perforée 118 pouvant être refroidie par exemple grâce à une circulation d'azote liquide. Le refroidissement cette plaque permet notamment d'améliorer, par condensation, la qualité du vide au voisinage de l'échantillon.

Après son passage au travers de la plaque 118, le faisceau d'électrons quitte la colonne électronique et termine son parcours en bombardant l'échantillon 11 à analyser.

Comme le montre la figure 1, l'échantillon à analyser est posé sur un support 12 qui est un élément conducteur. Par l'intermédiaire d'un générateur 119, l'échantillon est porté à un potentiel HV2 de même signe que le potentiel HV1. Le potentiel de référence du générateur 119 est relié à celui du générateur 14. De cette façon, la tension ΔV2 appliquée entre l'échantillon 11 et l'enceinte 115 est de même signe que la tension ΔV1 appliquée au dispositif d'émission d'électrons.

Dès sa sortie de l'espace sans champ électrique et juste avant la zone d'impacte avec l'échantillon, le faisceau d'électrons se trouve donc soumis à un champ électrique retardateur dont l'action va consister à freiner les électrons et donc à diminuer leur énergie. Le réglage de la différence de potentiel HV1 - HV2 entre la source d'électrons 13 et l'échantillon 11 est par exemple réalisé en jouant sur la valeur de la tension ΔV2. On peut ainsi choisir de faire varier la valeur du freinage auquel sont soumis les électrons en jouant simplement sur la valeur de ΔV2.

Il est donc avantageusement possible, en faisant varier la valeur de la différence de potentiel HV1 - HV2, de régler la valeur de l'énergie d'impact du faisceau d'électrons sur l'échantillon et donc sa profondeur de pénétration.

Un autre avantage lié à la création du champ retardateur après la dernière lentille de focalisation est l'augmentation considérable de la densité de courant d'électrons qui en résulte. L'augmentation de la densité de courant d'électrons a pour avantage d'accroître la sensibilité du dispositif. Cette augmentation de la densité de courant d'électrons provient de la limitation de la taille de la zone d'aberration du faisceau. La zone d'aberration est créée par le passage du faisceau à travers la lentille 116.

La plaque 118 peut également être conductrice et comporter une électrode permettant de la mettre à un potentiel qui peut par exemple varier entre la masse et le potentiel HV2 de l'échantillon 11 Si l'on porte par exemple la plaque 118 au potentiel HV2, la zone située entre cette plaque et l'échantillon devient également une zone sans champ électrique. Ceci permet avantageusement d'éviter qu'il ne se crée un flux d'ions susceptible d'éroder la surface de l'échantillon au cours de l'analyse. Une telle érosion aurait pour conséquence de fausser les résultats.

L'échantillon 11 à analyser est placé sur le support 12 à l'intérieur d'une enceinte 1112, ou chambre objet, perméable aux rayons X. Le support est par exemple susceptible de se déplacer, de façon à permettre un positionnement optimal de l'objet à analyser sous le faisceau d'électrons.

La chambre objet 1112, où est logé l'échantillon, est elle-même placée sous un vide sec et poussé, de l'ordre de $10^{-7}$ à $10^{-8}$ Torr. Ce vide est par exemple réalisé par l'utilisation d'une pompe turbo-moléculaire assistée d'un sublimateur de titane.

Une micro-fuite est placée au-dessus de l'échantillon. Son rôle est de permettre d'injecter dans certains cas un gaz quelconque et de dégrader localement le vide. Ceci favorise l'élimination des charges électrostatiques et d'éventuels éléments contaminant résiduels pouvant être piégés à la surface de l'échantillon.

Pour caractériser l'émission de rayons X caractéristiques de l'échantillon analysé, le dispositif selon l'invention comporte des moyens 1113 d'analyse spectrale. Ces moyens sont par exemple des spectromètres détecteurs de rayons X, de type WDS, connus par ailleurs. La figure 1 présente à titre d'exemple des détecteurs disposés dans la zone 114 de l'espace sans champ de façon inclinée autour de l'enceinte 115. La base de ces détecteurs est incorporée dans la lentille magnétique 116.

Le dispositif selon l'invention comporte également des moyens optiques permettant d'observer l'échantillon. Grâce à cette observation il est par exemple possible de déterminer le positionnement convenable en hauteur de l'échantillon, de façon à toujours disposer du meilleur rendement des spectromètres 1113. Ces moyens optiques comportent notamment un objectif catadioptrique 1114, un miroir de renvoi 1115, percé pour permettre le passage du faisceau d'électrons et une optique externe 1116.

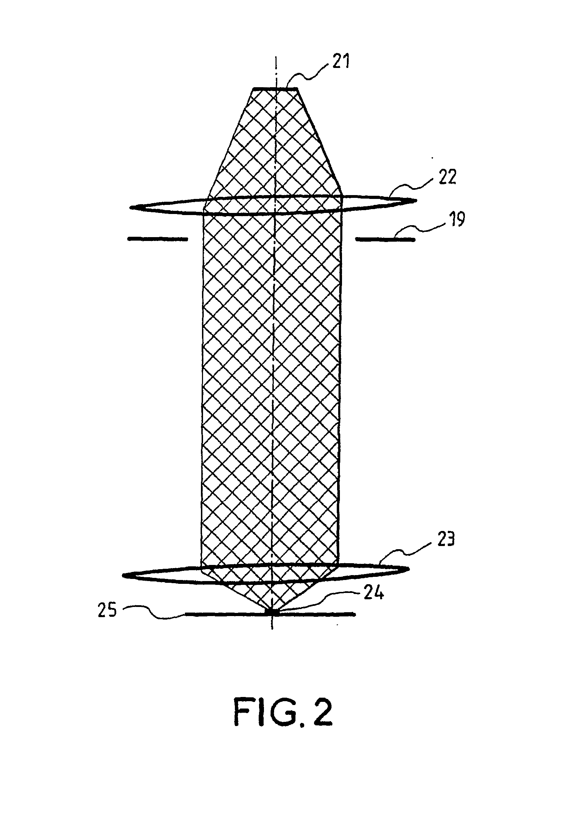

La figure 2 du document présente de façon schématique, par analogie optique, l'aspect du faisceau d'électrons créé par le dispositif selon l'invention. Sur ce schéma les lentilles électromagnétiques 18 et 116 de la figure 1 sont représentées par leurs équivalents optiques 22 et 23. Ces 2 lentilles forment un système afocal à l'intérieur duquel le faisceau est quasi parallèle. Le faisceau ainsi créé ne présente pas de zone de cross-over et a l'avantage de présenter moins d'aberrations dues aux interactions entre électrons. Ce phénomène d'aberration du faisceau, consécutif aux interactions entre électrons, est connu par ailleurs sous le nom d'effet BOERSCH.

Les distances relatives des différents éléments sont choisies en fonction de la taille du faisceau que l'on souhaite obtenir au plan de l'échantillon à analyser.

Si par exemple, la distance entre la source 21 et la lentille 22 est 4 fois plus grande que la distance entre la lentille 22 et la lentille 23, le système optique génère sur l'échantillon une image 24 de la source, réduite d'un facteur 4. Ainsi, si la source réelle représentée par la source idéale 21 a un diamètre typique de $60\mu$m, l'image de cette source formée au plan de l'échantillon sera d'environ $15\mu$m.

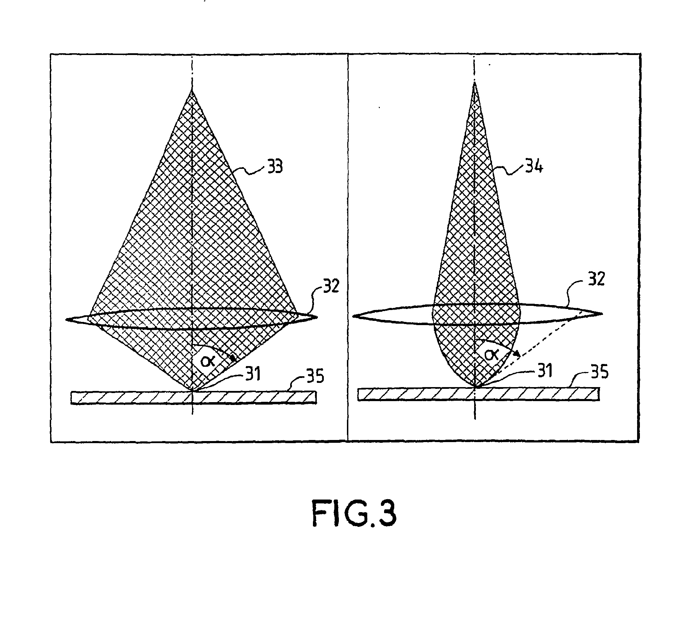

La figure 3 du document explique de façon imagée l'action du champ retardateur sur un faisceau d'électrons. La figure représente le trajet au travers d'une lentille d'un faisceau d'électrons issu d'une source ponctuelle et son image 31, ou spot, sur un plan 35. Sur l'illustration de gauche le faisceau 33 n'est soumis à aucun champ retardateur alors que sur l'illustration de droite un tel champ est appliqué au faisceau 34.

Il est connu que dans un système d'optique électronique, tant qu'on suppose que les aberrations des lentilles sont négligeables par rapport au diamètre du spot 31 considéré, la densité de courant du spot est donnée par:

$$J\ (A/cm^2) = \beta \ . \ \pi \ . \ \alpha^2 \qquad (1)$$

où $\alpha$ est le demi-angle d'ouverture du faisceau et $\beta$ la brillance du faisceau. $\beta$ ne dépend en première approximation que de la source d'électrons caractérisée par $\beta_0$ et de l'énergie que porte ces électrons qui est définie par le potentiel d'accélération V. On peut écrire :

$$\beta = \beta_0 \ . \ V \qquad (2)$$

Pour avoir une densité de courant maximum, on est donc amené à travailler avec la demi-ouverture $\alpha$ la plus grande possible, en utilisant la lentille 32 sur la totalité de sa section. Ceci a notamment pour conséquence que, vis à vis de la lentille, le diamètre du faisceau 33 n'est alors plus égal au diamètre gaussien $D_0$, pour lequel la traversée de la lentille se fait sans aberration. Il est égal à un diamètre réel $D_a$ déterminé par les aberrations du système optique. La densité de courant d'un spot est alors donnée par :

$$J\ (A/cm^2) = \beta \ . \ \pi \ . \ \alpha^2 \ . \ (D_0/D_a)^2 \qquad (3)$$

En première approximation les aberrations sphériques et chromatiques dépendent de la fraction de la section de la lentille objectif 116 qui est traversée par le faisceau. β ne dépend, quant à lui, que de l'énergie d'impact caractérisée par V. Dans les deux cas illustrés, l'énergie d'impact d'un électron $E_0$ est la même. Elle est donnée par :

$$E_0 = e.V \qquad (4).$$

Où e représente le module de la charge de l'électron et V la différence de potentiel à laquelle est soumis l'électron.

Dans le cas de la figure de gauche, il n'y a pas de champ retardateur entre la lentille 32 et le plan 35 : l'énergie des électrons est égale à $E_0$ sur tout le parcours. Dans le cas de la figure de droite en revanche, il existe un champ retardateur dont la présence va accroître l'énergie des électrons avant la lentille. Cet accroissement d'énergie va se traduire par une diminution de la taille du faisceau, la demi-ouverture α du faisceau 34 après la lentille restant par ailleurs identique.

D'après la loi de la brillance, les courants électroniques seront identiques, alors que la section de la lentille 32 traversée par le faisceau 34 est, dans le second cas, beaucoup plus réduite. Le diamètre de la zone d'aberration se trouve donc lui aussi réduit, ce qui conduit avantageusement à obtenir une densité de courant beaucoup plus élevée.

Si on considère par exemple des électrons dont l'énergie de 500eV est portée, grâce au champ retardateur, à 5000eV avant la lentille, la densité de courant obtenue est 4 fois plus élevée que dans le cas où les électrons sont véhiculés, sans champ retardateur, avec une énergie de 500eV tout au long du parcours.

Outre les éléments fonctionnels décrits précédemment, le dispositif selon l'invention peut comporter un sous-ensemble, par exemple électronique, dont le rôle est d'automatiser l'ensemble des commandes servant au pilotage des divers éléments que comporte le dispositif.

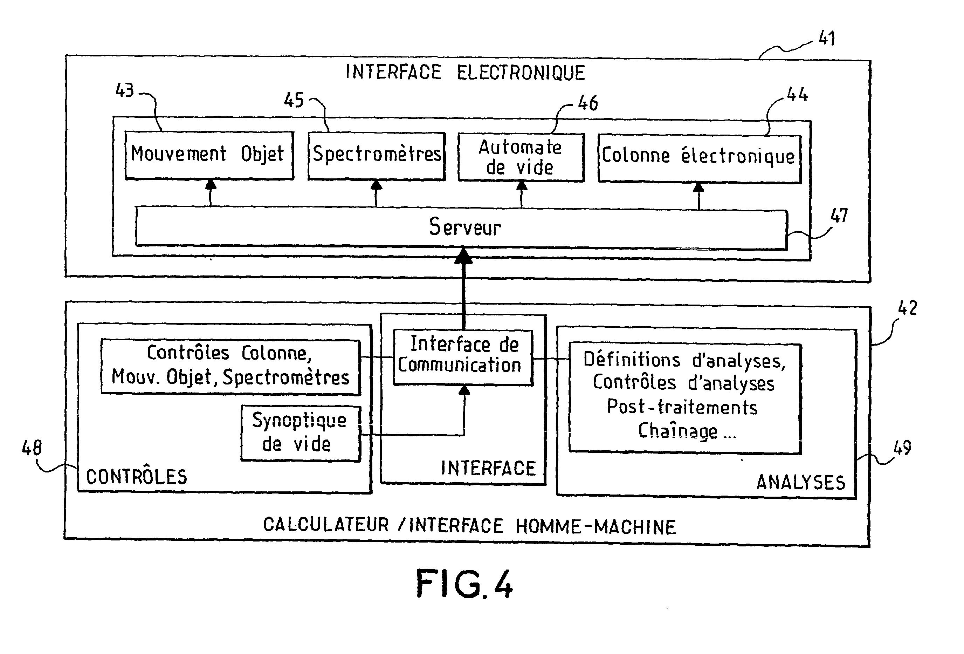

La figure 4 présente une architecture possible pour un tel sous-ensemble. Le sous-ensemble présenté est composé de deux éléments, une interface 41 et un calculateur 42.

L'interface comporte par exemple des cartes électroniques ayant chacune pour fonction de piloter une des grandes fonctions du dispositif. Ainsi on trouve :

- une carte électronique 43 chargée du contrôle des mouvements de l'échantillon à analyser,
- une carte électronique 44 contrôlant les différents éléments de la colonne électronique,
- une carte électronique 45 chargée de la mise en oeuvre des spectromètres,
- une carte électronique 46 contrôlant la mise sous vide du dispositif.

L'interface communique avec le calculateur 42 via une carte électronique serveur 47 qui interprète les ordres envoyés par le calculateur.

Le calculateur est une station de travail utilisateur, par exemple un PC fonctionnant dans un environnement Windows. Il est équipé d'une interface homme-machine graphique qui permet à l'opérateur d'accéder notamment à un contrôle interactif 48 du dispositif ainsi qu'à une gestion 49 des séquences automatiques d'analyse.

Le dispositif selon l'invention est associé à un protocole analytique menant à l'obtention de résultats quantitatifs quant à la composition élémentaire de l'échantillon. Ce protocole consiste à effectuer des mesures d'intensité du rayonnement X caractéristique des éléments présents dans l'échantillon. Les résultats sont obtenus en faisant varier l'énergie incidente des électrons primaires, puis en interprétant quantitativement ces mesures à l'aide d'un modèle de simulation approprié. L'énergie des électrons primaires est contrôlée par l'application des potentiels convenables sur l'échantillon et la source. Les mesures du courant de faisceau et du flux de photons X émis, font l'objet d'une acquisition par le système automatique décrit précédemment.

Les résultats de mesures sont inscrits par le calculateur dans un tableau constitué de N lignes. Chaque ligne du tableau regroupe l'ensemble des données relatives à une mesure. Pour chaque instant de mesure on trouve donc une ligne regroupant les données qui lui sont associées. Ces données sont par exemple l'instant de mesure, l'énergie d'impact des électrons calculée par la différence HV2-HV1, ainsi que la mesure du courant de faisceau mesuré par échantillonnage par le dispositif capteur d'électrons, et l'accumulation des photons X mesurée sur chacun des spectromètres.

Ainsi, il est par exemple possible au cours d'une analyse de faire évoluer de manière manuelle ou automatique, la valeur de l'énergie d'impact du faisceau et d'exploiter les résultats obtenus à l'aide d'un traitement numérique approprié. On peut alors déterminer les attributs essentiels d'une structure particulière de l'échantillon analysé. Ces attributs sont par exemple son épaisseur, la dose intégrée, c'est à dire le nombre d'atomes implantés par unité de surface, ou encore la distribution en profondeur associée à l'élément mesuré.

Les mesures élémentaires effectuées ici peuvent bien évidemment être reproduites sur tous les points de test d'une structure de type wafer. L'automatisation permet alors avantageusement d'effectuer sans intervention manuelle et de manière précise l'analyse complète d'un wafer.

**Revendications**

1. Dispositif de mesure de l'émission de rayons X produite par un objet (11) soumis à un faisceau d'électrons, **caractérisé en ce qu'**il comporte au moins:

   - Un sous-ensemble (13) comportant des moyens d'émission d'électrons et Un étage d'accélération dans lequel les électrons sont soumis à une différence de potentiel ΔV1 ;
   - Un espace sans champ électrique (15, 110, 114) dans lequel le faisceau d'électrons est mis en forme et contrôlé par des moyens appropriés (18, 19, 11, 116, 119);
   - Un étage de freinage dans lequel les électrons sont soumis à une différence de potentiel ΔV2 de même signe que ΔV1.
   - Un support (12) permettant de positionner l'objet (11) sous le faisceau d'électrons;
   - des moyens (1113) d'analyse spectrale des rayonnements X émis par l'objet analysé;

2. Dispositif selon la revendication 1, **caractérisé en ce que** les différences de potentiel ΔV1 et ΔV2 sont appliquées à l'aide de deux générateurs (14 et 119) dont les potentiels de référence sont reliés entre eux, le premier générateur (14) portant la source d'émission d'électron au potentiel HV1 et le deuxième générateur (118) portant l'objet à analyser (11) au potentiel HV2.

3. Dispositif selon la revendication 2, **caractérisé en ce que** les potentiels de référence (1111) des deux générateurs (14 et 119) sont reliés à la masse du dispositif.

4. Dispositif selon l'une quelconque des revendications 2 ou 3, **caractérisé en ce que** l'espace sans champ électrique (15, 110, 114) comporte des enceintes (16, 111, et 115) portées au potentiel de référence (1111) des deux générateurs (14 et 119).

5. Dispositif selon l'une quelconque des revendications précédentes, **caractérisé en ce qu'**il comporte une électrode (118) placée entre le support d'échantillon et le reste du dispositif, cette électrode pouvant être portée à un potentiel quelconque.

6. Dispositif selon la revendication 5, **caractérisé en ce que** cette électrode (118) est une plaque perforée, cette plaque pouvant être refroidie.

7. Dispositif selon l'une quelconque des revendications précédentes, **caractérisé en ce que** l'espace sans champ électrique (15, 110, 114) renferme des moyens (113) permettant de mesurer l'intensité du courant de faisceau.

8. Dispositif selon la revendication 7, **caractérisé en ce que** les moyens (113) permettant de mesurer l'intensité du courant de faisceau sont associés à des moyens de déviation (112) du faisceau d'électrons, ces moyens de déviation permettant de diriger le faisceau vers les moyens de mesure du courant d'électrons.

9. Dispositif selon la revendication 8, **caractérisé en ce que** les moyens de déviation (112) sont activés par un système électronique rapide permettant d'effectuer la mesure par échantillonnage, en cours d'analyse.

10. Dispositif selon l'une quelconque des revendications précédentes, **caractérisé en ce que** les moyens d'analyse spectrale (1113) comportent au moins un spectromètre WDS.

11. Dispositif selon l'une quelconque des revendications précédentes, **caractérisé en ce qu'**il comporte une chambre objet (1112) placée sous un vide sec et poussé.

12. Dispositif selon la revendication 1 1, **caractérisé en ce que** la chambre objet (1112) comporte une micro-fuite.

13. Dispositif selon l'une quelconque des revendications précédentes, **caractérisé en ce qu'**il comporte des moyens optiques permettant de visualiser l'objet analysé.

14. Dispositif selon la revendication 12, **caractérisé en ce que** les moyens optiques comportent au moins une optique catadioptrique (1114) placée au voisinage de l'objet, un miroir de renvoi (1115) percé, et un système optique externe (1116).

15. Dispositif selon l'une quelconque des revendications précédentes,
**caractérisé en ce qu'**il comporte une interface électronique (41) de commande et d'acquisition reliée aux différents éléments du dispositif, permettant le contrôle à distance du dispositif et l'acquisition des données correspondant aux mesures effectuées.

16. Dispositif selon la revendication 15, **caractérisé en ce qu'**il comporte un calculateur (42) relié à l'interface électronique (41) et équipée d'une interface homme-machine permettant de contrôler à distance différents éléments du dispositif et d'exploiter de manière automatique les mesures effectuées.

## Claims

1. Device for measuring the X-ray emission produced by an object (11) exposed to an electron beam, **characterized in that** it comprises at least:

    - a subassembly (13) comprising electron emission means and an acceleration stage in which the electrons are subjected to a potential difference $\Delta V1$;
    - a space with no electric field (15, 110, 114) in which the electron beam is shaped and controlled by suitable means (18, 19, 11, 116, 119);
    - a deceleration stage in which the electrons are subjected to a potential difference $\Delta V2$ of the same sign as $\Delta V1$;
    - a support (12) for positioning the object (11) beneath the electron beam; and
    - spectral analysis means (1113) for analyzing the X-rays emitted by the object being analyzed.

2. Device according to Claim 1, **characterized in that** the potential differences $\Delta V1$ and $\Delta V2$ are applied using two generators (14 and 119), the reference potentials of which are connected together, the first generator (14) raising the electron emission source to the potential HV1 and the second generator (119) raising the object to be analyzed (11) to the potential HV2.

3. Device according to Claim 2, **characterized in that** the reference potentials (1111) of the two generators (14 and 119) are connected to the ground of the device.

4. Device according to either of Claims 2 and 3,
**characterized in that** the space with no electric field (15, 110, 114) comprises enclosures (16, 1111 and 1115) that are raised to the reference potential (1111) of the two generators (14 and 119).

5. Device according to any one of the preceding claims, **characterized in that** it includes an electrode (118) placed between the specimen support and the rest of the device, this electrode being able to be raised to any potential.

6. Device according to Claim 5, **characterized in that** this electrode (118) is a perforated plate, which can be cooled.

7. Device according to any one of the preceding claims, **characterized in that** the space with no electric field (15, 110, 114) contains means (113) for measuring the intensity of the beam current.

8. Device according to Claim 7, **characterized in that** the means (113) for measuring the intensity of the beam current are associated with electron beam deflection means (112), these deflection means allowing the beam to be directed onto the means for measuring the electron current.

9. Device according to Claim 8, **characterized in that** the deflection means (112) are activated by a rapid electronic system, allowing the measurement to be performed by sampling, during analysis.

10. Device according to any one of the preceding claims, **characterized in that** the spectral analysis means (1113) comprise at least one WDS spectrometer.

11. Device according to any one of the preceding claims, **characterized in that** it includes an object chamber (1112) placed in a high-dry vacuum.

12. Device according to Claim 11, **characterized in that** the object chamber (1112) includes a microleak.

13. Device according to any one of the preceding claims, **characterized in that** it includes optical means for displaying the object analyzed.

14. Device according to Claim 12, **characterized in that** the optical means include at least one catadioptric optic (1114) placed near the object, a pierced deflection mirror (1115) and an external optical system (1116).

15. Device according to any one of the preceding claims, **characterized in that** it includes an electronic command and acquisition interface (41) connected to the various elements of the device, allowing remote control of the device and acquisition of the data corresponding to the measurements carried out.

16. Device according to Claim 15, **characterized in that** it includes a computer (42) connected to the electronic interface (41) and equipped with a man-machine interface for remotely controlling the various elements of the device and for automatically exploiting the measurements made.


**Patentansprüche**

1. Vorrichtung zur Messung der Emission von Röntgenstrahlen, die von einem Objekt (11) erzeugt wird, das einem Elektronenstrahl ausgesetzt wird, **dadurch gekennzeichnet, dass** sie mindestens aufweist:

   - eine Untereinheit (13), die Mittel zur Elektronenemission und eine Beschleunigungsstockwerk aufweist, in der die Elektronen einer Potentialdifferenz $\Delta V1$ ausgesetzt werden;
   - einen Raum ohne elektrisches Feld (15, 110, 114), in dem der Elektronenstrahl geformt und von geeigneten Mitteln (18, 19, 11, 116, 119) überwacht wird;
   - eine Bremsstockwerk, in der die Elektronen einer Potentialdifferenz $\Delta V2$ gleichen Vorzeichens wie $\Delta V1$ ausgesetzt werden;
   - einen Träger (12), der es ermöglicht, das Objekt (11) unter dem Elektronenstrahl anzuordnen;
   - Mittel (1113) zur Spektralanalyse der vom analysierten Objekt emittierten Röntgenstrahlen.

2. Vorrichtung nach Anspruch 1, **dadurch gekennzeichnet, dass** die Potentialdifferenzen $\Delta V1$ und $\Delta V2$ mit Hilfe von zwei Generatoren (14 und 119) angelegt werden, deren Bezugspotentiale miteinander verbunden sind, wobei der erste Generator (14) die Elektronen-Emissionsquelle auf das Potential HV1 und der zweite Generator (119) das zu analysierende Objekt (11) auf das Potential HV2 bringt.

3. Vorrichtung nach Anspruch 2, **dadurch gekennzeichnet, dass** die Bezugspotentiale (1111) der beiden Generatoren (14 und 119) mit der Masse der Vorrichtung verbunden sind.

4. Vorrichtung nach einem der Ansprüche 2 oder 3, **dadurch gekennzeichnet, dass** der Raum ohne elektrisches Feld (15, 110, 114) Bereiche (16, 111 und 115) aufweist, die auf das Bezugspotential (1111) der beiden Generatoren (14 und 119) gebracht sind.

5. Vorrichtung nach einem der vorhergehenden Ansprüche, **dadurch gekennzeichnet, dass** sie eine Elektrode (118) aufweist, die zwischen dem Probenträger und dem Rest der Vorrichtung angeordnet ist, wobei diese Elektrode auf ein beliebiges Potential gebracht werden kann.

6. Vorrichtung nach Anspruch 5, **dadurch gekennzeichnet, dass** diese Elektrode (118) eine Lochplatte ist, wobei diese Platte gekühlt sein kann.

7. Vorrichtung nach einem der vorhergehenden Ansprüche, **dadurch gekennzeichnet, dass** der Raum ohne elektrisches Feld (15, 110, 114) Mittel (113) umschließt, die es ermöglichen, die Stärke des Strahlstroms zu messen.

8. Vorrichtung nach Anspruch 7, **dadurch gekennzeichnet, dass** die Mittel (113), die es ermöglichen, die Stärke des Strahlstroms zu messen, Mitteln (112) zur Umlenkung des Elektronenstrahls zugeordnet sind, wobei diese Umlenkungsmittel es ermöglichen, den Strahl zu den Mitteln zur Messung des Elektronenstroms zu leiten.

9. Vorrichtung nach Anspruch 8, **dadurch gekennzeichnet, dass** die Umlenkmittel (112) von einem schnellen Elektroniksystem aktiviert werden, das es ermöglicht, die Messung durch Tastung während der Analyse durchzuführen.

**10.** Vorrichtung nach einem der vorhergehenden Ansprüche, **dadurch gekennzeichnet, dass** die Spektralanalysemittel (1113) mindestens ein WDS-Spektrometer aufweisen.

**11.** Vorrichtung nach einem der vorhergehenden Ansprüche, **dadurch gekennzeichnet, dass** sie eine Objekt-Kammer (1112) aufweist, die sich in einem trockenen Hochvakuum befindet.

**12.** Vorrichtung nach Anspruch 11, **dadurch gekennzeichnet, dass** die Objekt-Kammer (1112) ein Mikro-Leck aufweist.

**13.** Vorrichtung nach einem der vorhergehenden Ansprüche, **dadurch gekennzeichnet, dass** sie optische Mittel aufweist, die es ermöglichen, das analysierte Objekt anzuzeigen.

**14.** Vorrichtung nach Anspruch 12, **dadurch gekennzeichnet, dass** die optischen Mittel mindestens eine katadioptrische Optik (1114), die in der Nähe des Objekts angeordnet ist, einen gelochten Umlenkspiegel (1115) und ein externes optisches System (1116) aufweisen.

**15.** Vorrichtung nach einem der vorhergehenden Ansprüche, **dadurch gekennzeichnet, dass** sie eine elektronische Schnittstelle (41) zur Steuerung und Erfassung aufweist, die mit den verschiedenen Elementen der Vorrichtung verbunden ist und die Fernüberwachung der Vorrichtung und die Erfassung der den durchgeführten Messungen entsprechenden Daten ermöglicht.

**16.** Vorrichtung nach Anspruch 15, **dadurch gekennzeichnet, dass** sie einen Rechner (42) aufweist, der mit der elektronischen Schnittstelle (41) verbunden und mit einer Mensch-Maschine-Schnittstelle ausgestattet ist, die es ermöglicht, verschiedene Elemente der Vorrichtung aus der Ferne zu überwachen und automatisch die durchgeführten Messungen auszuwerten.

FIG.1

FIG. 2

FIG.3

FIG.4

EP 1 490 888 B1